# EUROPEAN PATENT APPLICATION

(11) **EP 4 019 673 A1**
(43) Date of publication of application: **29.06.2022**
(21) Application number: 21205710.3
(22) Date of filing: 29.10.2021
(51) Int. Cl.: C30B 29/30, C30B 29/32, C01G 23/00, C01G 33/00, H01L 41/187

(54) **METHODS FOR PRODUCING A COMPOSITION WITH A FERROELECTRIC PEROVSKITE PRIMARY PHASE AND A TUNABLE SECONDARY CRYSTALLINE PHASE OF RELAXOR-DIELECTRIC, ASSOCIATED COMPOSITIONS, AND ASSOCIATED DEVICES**

(30) Priority: 30.11.2020 US 202017107339
(71) Applicant: NXP USA, Inc., Austin TX 78735 (US)
(72) Inventor: Zelner, Marina, 5656 AG Eindhoven (NL); Cervin, Andrew Vladimir Claude, 5656 AG Eindhoven (NL)
(74) Representative: Miles, John Richard

(57) **Abstract**

A method that incorporates teachings of the subject disclosure may comprise, for example, selecting a barium-strontium-titanate (BST) material, wherein the BST material has a perovskite lattice structure with at least a first lattice constant and a second lattice constant; selecting a strontium-barium-niobate (SBN) material, wherein the SBN material has a lattice structure with at least a third lattice constant and a fourth lattice constant, wherein the third lattice constant is substantially equal to the first lattice constant, and wherein the fourth lattice constant is substantially equal to the second lattice constant; and growing, on a grain boundary region of the BST material, the SBN material, wherein the growing is via self-assembly, and wherein the growing is facilitated by the third lattice constant of the SBN material being substantially equal to the first lattice constant and the fourth lattice constant of the SBN material being substantially equal to the second lattice constant. Other embodiments are disclosed.

## Description

### FIELD OF THE DISCLOSURE

The subject disclosure relates to methods for producing a composition with a ferroelectric perovskite primary phase and a tunable secondary crystalline phase of relaxor-dielectric, associated compositions, and associated devices.

### BACKGROUND

The existence of strontium-barium-niobate (SBN) crystals (SrₓBa₁₋ₓ NB₂O₆) was reported in 1960 (see Francombe, M.H. Acta Cristallographica, Vol. 13, (1960), pp. 131).

In 1970, Bell Labs published successive investigations of the optical, electrical and structural properties of SBN crystals. The high values of the electro-optic and pyroelectric coefficients oriented further work mainly towards holographic and pyroelectric applications.

The monocrystalline SBN exhibits one of the largest known linear electro-optic coefficients (nearly two orders of magnitude larger than that of the primary electro-optic LiNbO₃). Thin films of SBN are attractive for their potential use as low voltage electro-optic waveguides.

Crystalline SBN is a relaxor-ferroelectric which has been widely studied in 1980-2005 for holographic recording and optical processing. It is believed that the only known practical use to date has been in holographic imaging applications. This was in the context of the material being Ce-doped SBN utilizing high four-wave coupling (see Ivanov, et al., Ferroelectric Domain Structure in SBN Crystals (Its Statics and Dynamics), Crystallography Reports, Vol. 47, No. 6, 2002, pp. 1023-1030. Translated from Kristallografiya, Vol. 47, No. 6, 2002, pp. 1092-1099).

Since SBN was primarily qualified for optical applications, the high frequency dielectric properties were typically not studied in detail (reported has been a dielectric constant of SBN in thin film of approximately 1000-1800 and tunability of approximately 3:1).

### SUMMARY

Aspects of the disclosure are defined in the accompanying claims. In a first aspect there is provided a method, comprising: selecting a barium-strontium-titanate (BST) material, wherein the BST material that is selected has a perovskite lattice structure with at least a first lattice constant and a second lattice constant; selecting a strontium-barium-niobate (SBN) material, wherein the SBN material that is selected has a lattice structure with at least a third lattice constant and a fourth lattice constant, wherein the third lattice constant is substantially equal to the first lattice constant, and wherein the fourth lattice constant is substantially equal to the second lattice constant; and growing, on a grain boundary region of the BST material, the SBN material, wherein the growing is via self-assembly, and wherein the growing is facilitated by the third lattice constant of the SBN material being substantially equal to the first lattice constant and the fourth lattice constant of the SBN material being substantially equal to the second lattice constant.

In one or more embodiments, the BST material that is selected is in a form of Ba1-xSrxTiO, and wherein x is in a range of 0.55-0.8, inclusive. In one or more embodiments, the SBN material that is selected is in a form of SrxBa1-xNb2O6, and wherein x is in a range of 0.5-0.7, inclusive.

In one or more embodiments, the SBN material being grown on the BST material results in a combined composition, and wherein presence of the SBN material on the grain boundary region provides a higher tuning ratio for the combined composition than would otherwise be provided without the growth on the grain boundary region.

In one or more embodiments, the growing comprises crystallization. In one or more embodiments, the SBN material being grown on the BST material results in a tunable dielectric composition. In one or more embodiments, the BST material that is selected comprises between 80%-99.9%, inclusive, of a total composition including the BST material that is selected and the SBN material that is selected; and the SBN material that is selected comprises between 0.1%-20%, inclusive, of the total composition including the BST material that is selected and the SBN material that is selected.

In one or more embodiments, the first lattice constant is equal to the second lattice constant; and the third lattice constant is substantially equal to the first lattice constant, the second lattice constant and the fourth lattice constant.

In one or more embodiments,: the third lattice constant of the SBN material being substantially equal to the first lattice constant comprises the third lattice constant matching the first lattice constant within a threshold equal to +/- 0.5%; and the fourth lattice constant of the SBN material being substantially equal to the second lattice constant comprises the fourth lattice constant matching the second lattice constant within the threshold equal to +/- 0.5%.

In a second aspect, there is provided a tunable dielectric material, comprising: a first layer formed of barium-strontium-titanate (BST), wherein the first layer comprises a grain boundary region, and wherein the BST in the grain boundary region of the first layer has a first lattice structure with first, second and third lattice constants; and a second layer formed of strontium-barium-niobate (SBN) that is crystallized on the first layer, wherein the second layer has a second lattice structure with fourth, fifth and sixth lattice constants, wherein two of the fourth, fifth and sixth lattice constants substantially match two respective ones of the first, second and third lattice constants, and wherein the two of the fourth, fifth and sixth lattice constants substantially matching the two of the respective ones of the first, second and third lattice constants facilitates the second layer being crystallized on the first layer via self-assembly.

In one or more embodiments, the BST is in a form of Ba1-xSrxTiO, and wherein x is in a range of 0.55-0.8, inclusive. In one or more embodiments, the SBN is in a form of SryBa1-yNb2O6, and wherein y is in a range of 0.5-0.7, inclusive. In one or more embodiments, the crystallization of the second layer on the grain boundary region of the first layer provides a higher tuning ratio for the tunable dielectric material than would otherwise be provided without the crystallization. In one or more embodiments, the BST comprises between 80%-99.9%, inclusive, of a total composition including the BST and the SBN; and the SBN comprises between 0.1%-20%, inclusive, of the total composition including the BST and the SBN.

In one or more embodiments, the first lattice constant equals the second lattice constant, wherein the two of the fourth, fifth and sixth lattice constants substantially matching the two respective ones of the first, second and third lattice constants comprises a first one of the fourth, fifth and sixth lattice constants matching a first one of the first, second and third lattice constants within a threshold equal to +/- 0.5% and a second one of the fourth, fifth and sixth lattice constants matching a second one of the first, second and third lattice constants within the threshold equal to +/- 0.5%.

In a third aspect there is provided a tunable dielectric material, comprising: a barium-strontium-titanate (BST) material, the BST material comprising a grain boundary region, the BST material in the grain boundary region having a first lattice structure with at least a first lattice constant and a second lattice constant; and a strontium-barium-niobate (SBN) material, the SBN material having a second lattice structure with at least a third lattice constant and a fourth lattice constant, the third lattice constant being substantially equal to the first lattice constant, the fourth lattice constant being substantially equal to the second lattice constant, and the SBN material being in crystalline form that is disposed via self-assembly at the grain boundary region.

In one or more embodiments, the SBN material being in crystalline form that is disposed at the grain boundary region provides a higher tuning ratio for the tunable dielectric material than would otherwise be provided without the presence of the SBN material in crystalline form; the first lattice constant is equal to the second lattice constant; and the third lattice constant is substantially equal to the first lattice constant, the second lattice constant and the fourth lattice constant. In one or more embodiments, the BST material is in a form of Ba1-xSrxTiO, and wherein x is in a range of 0.55-0.8, inclusive.

In one or more embodiments, the SBN material is in a form of SrxBa1-xNb2O6, and wherein x is in a range of 0.5-0.7, inclusive.

In one or more embodiments, the BST material comprises between 80%-99.9% of a total composition including the BST material and the SBN material; and the SBN material comprises between 0.1%-20% of the total composition including the BST material and the SBN material.

### BRIEF DESCRIPTION OF THE DRAWINGS

Reference will now be made to the accompanying drawings, which are not necessarily drawn to scale, and wherein:
**FIG. 1A** depicts a diagram of a barium-strontium-titanate (BST) crystal elementary cell and a strontium-barium-niobate (SBN) crystal elementary cell, each of which can have certain lattice constants that are selected in accordance with various aspects described herein.
**FIG. 1B** depicts a diagram of a different view of a strontium-barium-niobate (SBN) crystal elementary cell, which can have certain lattice constants that are selected in accordance with various aspects described herein.
**FIG. 2** depicts an SBN teranary phase diagram in accordance with various aspects described herein.
**FIG. 3A** depicts a graph of Ba₁₋ₓSrₓ, TiO lattice parameters versus composition in accordance with various aspects described herein.
**FIG. 3B** depicts a graph of SBN lattice parameters as a function of the Sr content x (circles and squares) and single-crystal (filled triangles) in accordance with various aspects described herein.
**FIG. 4** depicts a method in accordance with various aspects described herein.
**FIGs. 5A, 5B, and 5C** depict representations of various crystals and self-assemblies in accordance with various aspects described herein.
**FIG. 6** depicts a communication device in accordance with various aspects described herein.
**FIG. 7** depicts a portion of a transceiver of the communication device of **FIG. 6** in accordance with various aspects described herein.

### DETAILED DESCRIPTION

The subject disclosure relates to methods for producing a composition with a tunable secondary crystalline phase of relaxor-dielectric, associated compositions, and associated devices. In one embodiment, the subject disclosure relates to a method of producing a tunable polycrystalline perovskite dielectric with a self-assembled tunable secondary crystalline phase of relaxor-dielectric. In another embodiment, the subject disclosure relates to a tunable polycrystalline perovskite dielectric with a self-assembled tunable secondary crystalline phase of relaxor-dielectric. In another embodiment, the subject disclosure relates to a tunable polycrystalline perovskite composition with a self-assembled tunable secondary crystalline phase of relaxor-dielectric. Other embodiments are described by the subject disclosure.

As described herein, the dielectric constant of BST in the polycrystalline bulk ceramic is approximately 3000-5000. The dielectric constants of the BST thin films of different Ba/Sr ratio are approximately 10x lower than the bulk ceramic of the same composition. In this regard, factors suppressing the dielectric constant of certain ferroelectrc thin films are: (a) "dead layers" in the dielectric film/electrode interface; (b) non-tunable "dead layers" at the grain boundaries; (c) ferroelectric domains and nano-domains.

Accordingly, various embodiments may make use of the circumstance that the lattice parameters of BST and SBN can be very supportive for the growing of, for example, a nearly planar (e.g., approximately 2D) self-aligned minority phase at the grain boundary, on the grain boundary, in the grain boundary, or any combination thereof (e.g., in one or more embodiments, the template crystallization (self-aligning) can be possible if at least 2 lattice constants of different crystalline systems are matching). In one embodiment, the grain boundary can be the preferred state because of the lowest energy state in the crystalline field.

Improvement in Q (quality factor) may be achievable by using perovskite dielectrics with the compositions having Ba:Sr ratios of less than 0.45:0.55 and Tc much lower than the operational range of the devices. A desired tuning ratio may be achieved by modifying the interstitial "dead layer" between the grains into a secondary tunable phase. In one embodiment, the tunable material can be a composite having a perovskite majority phase (as in certain conventional approaches) and a relaxor-dielectric minority phase self-assembled in the grain boundary region. The self-assembled template crystallization of the minority phase can be achieved by choosing the composition of the secondary tunable relaxor-dielectric phase with a close matching of, for example, 2 out of 3 lattice parameters to those of the majority perovskite phase.

Various objectives of higher tuning, higher Q (quality factor) and lower harmonics may be achievable (e.g., in one or more embodiments, achievement of such objectives may facilitate production of devices that compete favorably against certain switched capacitors (which typically have much lower 3rd harmonics relative to various conventional dielectric devices but which are typically larger and more expensive)).

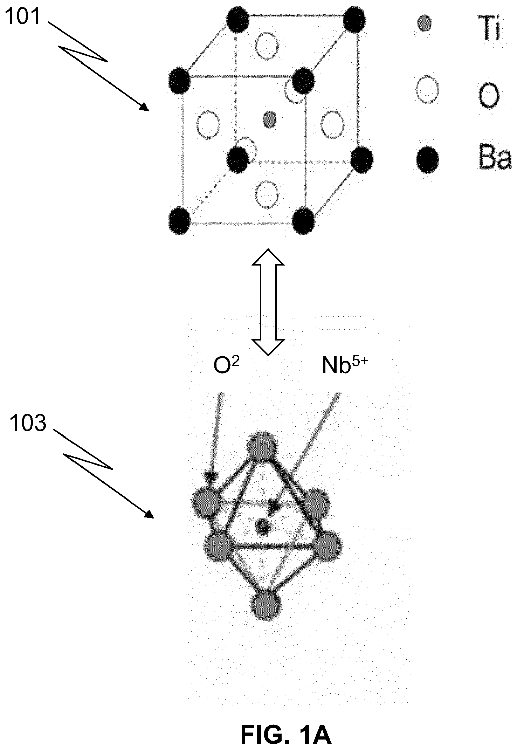

Referring now to **FIG. 1A****,** this depicts a diagram of a barium-strontium-titanate (BST) crystal elementary cell 101 and a strontium-barium-niobate (SBN) crystal elementary cell 103, each of which can have certain lattice constants that are selected according to various embodiments. BST is a strontium-substituted barium titanate. The Sr substitutes for the Ba in the elementary cell. The degree of substitution could be from 0% (pure barium titanate) to 100% (pure strontium titanate). In BST, all three lattice parameters (or constants) are equal. Similar to BST, SBN is a barium-substituted strontium titanate. In another embodiment, the BST can have a distorted cubic crystalline modification. In another embodiment, the BST can have a tetragonal crystalline modification.

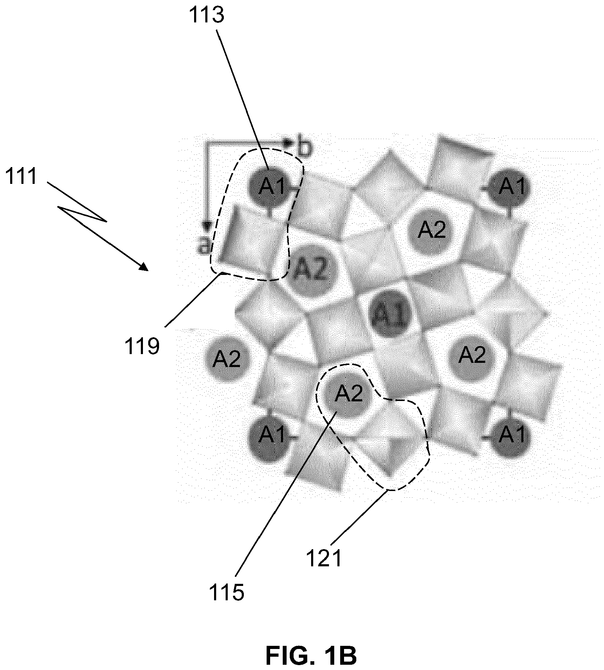

Referring now to **FIG. 1B****,** this depicts a diagram of a top view of a network 111 of strontium-barium-niobate (SBN) crystal elementary cells (including elementary cell 119 viewed with the interstitial site A1 and elementary cell 121 viewed with the interstitial site A2), which can have certain lattice constants that are selected according to various embodiments. In this figure, the view is showing the SBN portion, and the complementary BST portion is not shown. Rings are made of five NbO₆ octahedra from three types of interstitial states. The tetragonal (A1) positions (one of which is identified by call out number 113) and the pentagonal (A2) positions (one of which is identified by call out number 115) are occupied by Sr and Ba atoms and are partially vacant. In SBN, two lattice parameters (or constants) are equal and the third is 3x larger. The square elements in this **FIG. 1B** (one of which is included with call out number 119 and one of which is included with call out number 121) represent niobium and oxygen. Sites A1 and A2 could be shared with BST fully or partially.

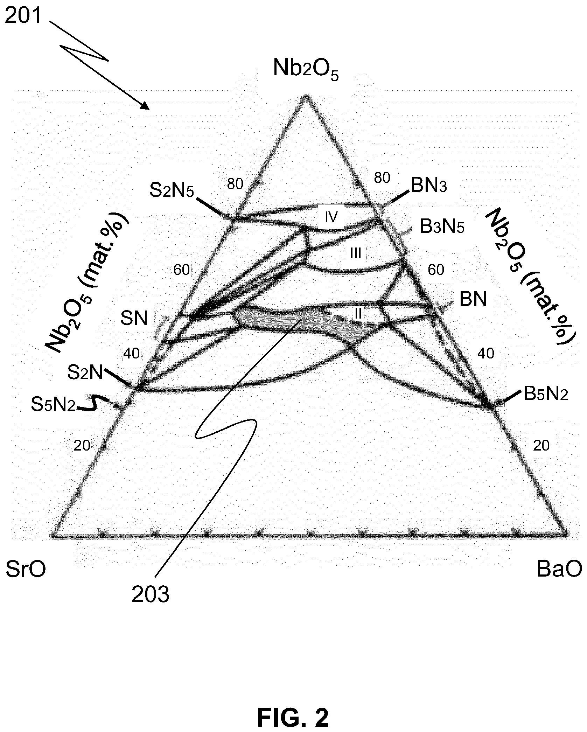

Referring now to **FIG. 2**, this depicts an SBN teranary phase diagram 201. This diagram 201 is based upon Carruthers, J.R. & Grasso, M. (1970). Phase equilibria relations in the ternary system BaOSrO-Nb2O5 are depicted. Journal of Electrochemical Society Vol. 117, No. 11, (November 1970), pp. 1426-1430. The original diagram has been modified by identifying the shaded field with call out number 203. The shaded field 203 in this view indicates the existence region of TTB SBN phase (Sr 0.3-0.7, (Ba+Sr)/Nb = 1). The BN and SN phases might crystallize and coexist at the Ba/Sr ratio of approximately 0.3/0.7 to approximately 0.7/0.3. The non-stoichiometries could be eliminated by precise control of Ba/Nb and Sr/Nb ratios. In various embodiments, by controlling the process conditions and selecting particular lattice constants, a stable phase of SBN could be maintained as shown at 203.

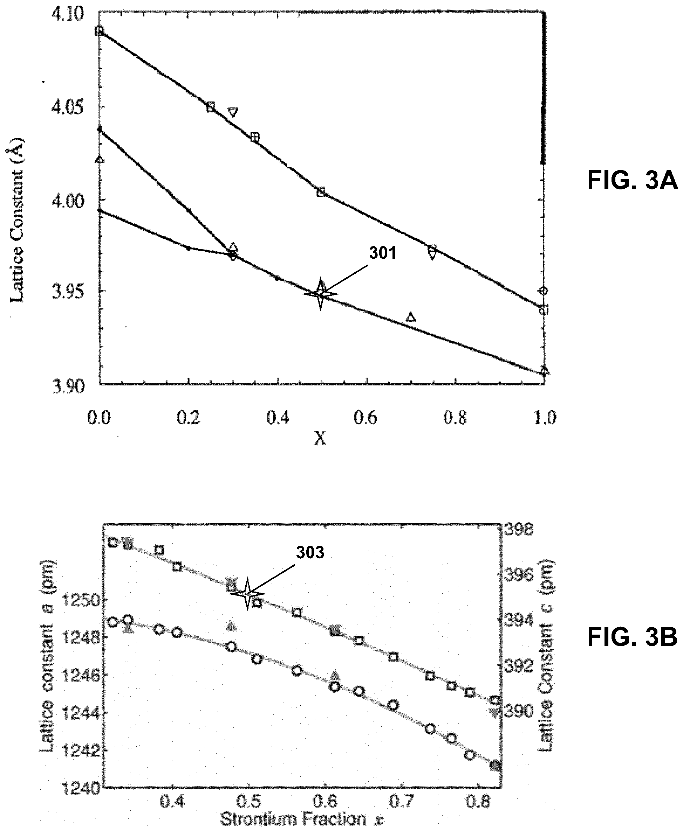

Referring now to **FIG. 3A**, this depicts a graph of Ba₁₋ₓSrₓ, TiO lattice parameters vs. composition. This graph is based upon T. Remmel, et al. in CPDS-International Centre for Diffraction data 1999ISSN 1097-0002, Advances in X-ray Analysis, Volume 41. The original graph has been modified by removing the legend and adding the indicated point at call out number 301. Each of the various plotted points (other than 301) represent various data points indicating lattice constants based on various processes and techniques and stoichiometric selections. Further, referring to **FIG. 3B**, this depicts a graph of SBN lattice parameters as a function of the Sr content x. Each of the various plotted points (other than 303) represent various data points indicating lattice constants based on various processes and techniques and stoichiometric selections. This graph is based upon S. Podlozhenov et al. in Acta Cryst. (2006). B62, p960-965. The original graph has been modified by adding the indicated point at call out number 303. As shown in these **FIGS. 3A and 3B****,** the possibility is illustrated for the planar growth of the relaxor (SBN) phase according to various embodiments. Lattice constants of BST and SBN of the same Ba/Sr ratio have 2 out of 3 matching values so a layered superlattice structure can be favored. Call out number 301 in **FIG. 3A** and call out number 303 in **FIG. 3B** indicate two example points where lattice constants of BST and SBN match according to one or more embodiments. **FIG. 3A** shows lattice constant in angstroms and **FIG. 3B** shows lattice constant in pico-meters.

As described herein in connection with various embodiments, various compositions and structures of dielectrics may be provided that are well suited for newer mobile communication systems which have much more stringent IP3 requirements, such as carrier aggregation and 5G.

As described herein in connection with various embodiments, various compositions and structures of dielectrics may be provided which remove (or alleviate) the trade-off between tuning, Q (quality factor) and IP3 parameters.

Various embodiments can provide a tunable dielectric composition based on (Ba/Sr)TiₓMe_{y}O_{z} quaternary system where Ba/Sr<0.5.

Desired capacitance density and tuning of the BST with a Ba/Ti ratio of approximately 0.2-0.45 may be achieved by transformation of a "dead layer" of the grain boundary into a tunable high-K minority phase. For that purpose, a self-aligned 2D (or nearly 2D) layer of a relaxor-ferroelectric may be grown at the grain boundaries of the BST. Increase of the dielectric constant and tuning are expected because relaxor-ferroelectrics are tunable and have higher dielectric constants than regular ferroelectrics. In one embodiment, a potential relaxor-dielectric phase is: SBN SrₓBa₁₋ₓNb₂O₆.

Recovery (relative to certain conventional approaches) of capacitance density and tuning ratio may be provided for certain dielectric compositions (e.g., with low Ba/Sr ratio of Ba(∼0.3-0.45)/Sr(0.7-0.65)).

Improvement of the RF properties (relative to certain conventional approaches) may be provided in a high frequency response Q, H3 H3 is the third harmonic produced within a non-linear BST dielectric. It relates to the intermodulation distortion (IMD or IP3). IP3 is undesired and should be minimized in a device. Improvement of the tuning ratio over the BST baseline may be provided in the CV curve.

In one or more embodiments, a composite dielectric of barium-strontium-titanate modified by strontium-barium-niobate (BST-SBN) may be provided with the stable majority and minority phases coexisting in a temperature range of -40C to 75C (250-350K).

In one or more embodiments, a composition can be doped with known donor or acceptor dopants, where the trace amounts of dopants are not generating separate phases. In various embodiments, these dopants may not be required.

Certain details of a BST-SBN composition according to an embodiment may be as follows: (a) Majority phase of BST (80-99.9%) - Ba/Sr ratio of 0.2-0.5. Crystal system: Cubic (Perovskite). In this context, BST is a ferroelectric with a high-K and a distinct Curie-Weiss Temperature (Tc) defined by Ba/Sr ratio; (b) Minority phase of SBN (0.1-20%) is a modifier of the combined crystalline lattice - Crystal system: Tetragonal di-pyramidal (Tungsten Bronze). In this context, SBN is a relaxor-dielectric with no defined Tc and a dielectric constant of ∼3-10× higher than perovskite dielectrics of the corresponding Ba/Sr ratio.

Various embodiments can provide for a tunable polycrystalline perovskite dielectric with a self-assembled tunable secondary crystalline phase of relaxor-dielectric.

In one or more embodiments, a dielectric (e.g., a dielectric composition) may be provided that combines high tuning with low loss (high Q).

In one or more embodiments, recovery of some tuning may be provided. For instance, a low loss dielectric material (which can be advantageous) may have grown on and/or in a "dead layer" thereof an additional material that in aggregate with the low loss dielectric material may provide for an increase (which can be advantageous) in tuning ratio (relative to the low loss dielectric material itself).

Various embodiments can provide growth (e.g., crystallization) in at least two dimensions on a 3D structure.

In one or more embodiments, a dielectric may be provided with high tuning and low loss (high Q).

In one or more embodiments, it is anticipated that the tunability will increase faster than the loss as the SBN phase is added to the BST material.

Various embodiments can be enabled due to the possibility for planar growth of a relaxor (SBN) phase that is facilitated by the lattice constants of BST and SBN of the same Ba/Sr ratio having 2 out of 3 matching values (see, e.g., **FIGS. 3A and** 3B). In one or more embodiments, a layered superlattice can be favored.

Referring now to Tables 1 and 2 below, BST lattice constants (Table 1) and SBN lattice constants (Table 2) according to various embodiments are shown.

**Table 1 - BST lattice constants**

| Ba/Sr | a | b | c |
|---|---|---|---|
| 50/50 | 4.01 | 4.01 | 4.01 |
| 40/60 | 3.98 | 3.98 | 3.98 |
| 30/70 | 3.96 | 3.96 | 3.96 |
| 20/80 | 3.93 | 3.93 | 3.93 |

**Table 2 - SBN lattice constants**

| Ba/Sr | a | b | c |
|---|---|---|---|
| 50/50 | 3.96 | 3.96 | 12.49 |
| 40/60 | 3.95 | 3.95 | 12.46 |
| 30/70 | 3.92 | 3.92 | 12.43 |
| 20/80 | 3.85 | 3.85 | 12.4 |

Still referring to Tables 1 and 2 above, a description of self-assembly according to various embodiments is as follows: (I) Each crystal has three lattice constants (a,b,c for x,y,z dimensions); (II) Perovskite is cubic. That means that in the major phase (1) a1=b1=c1. Minority phase (2) - Tungsten Bronze (Niobate) has a2=b2<<c2; (III) The condition of self-assembly at the grain boundary according to these embodiments would be: a1=a2=b1=b2<<c2 while the mismatch of the matching parameters would be within +/-0.5%.

In another description of self-assembly according to various embodiments, such self-assembly means that the secondary (or minority) phase will crystallize at the crystallization conditions (T,P) of the primary (or major) phase with no additional forces necessary for the nucleation and crystal formation -- particularly at the grain boundary.

Still referring to self-assembly according to various embodiments, in these embodiments the secondary phase must have only 2 out of 3 matching lattice constants (relative to the primary phase) for self-assembly at the grain boundary. If, for example, 3 out of 3 lattice constants match then the self-assembly would not take place and the secondary phase material would be incorporated into the primary crystal structure.

In another embodiment, one lattice constant can match another lattice constant within a threshold of +/- 1.0%. In another embodiment, one lattice constant can match another lattice constant within a threshold of +/- 5%.

In various embodiments, precursors for both crystalline phases are present in each single layer. In various embodiments, the crystallized polycrystalline film consists of grains and grain boundaries within the same layer. The grain boundary of polycrystalline BST usually consists of the same BST with much higher crystalline distortion and higher density of defects (so called "dead layer"). Various embodiments modify this dead layer, providing conditions for the crystallizing the secondary tunable phase (in various embodiments, this secondary phase is more tunable and more lossy than BST). In various embodiments, crossover dielectric has overall low loss because for >80% it consists of a low loss/low tuning BST.

As described herein, in one embodiment, the subject disclosure relates to a method of producing a tunable polycrystalline perovskite dielectric with a self-assembled tunable secondary crystalline phase of relaxor-dielectric. In another embodiment, the subject disclosure relates to a tunable polycrystalline perovskite dielectric with a self-assembled tunable secondary crystalline phase of relaxor-dielectric. In another embodiment, the subject disclosure relates to a tunable polycrystalline perovskite composition with a self-assembled tunable secondary crystalline phase of relaxor-dielectric.

As described herein, various embodiments can improve upon certain conventional tunable perovskite dielectrics (such as certain polycrystalline single-phase perovskite dielectrics of various chemical compositions, grain structures, and crystalline orientations) that can typically achieve necessary tuning ratios of 3-7:1 (if their Tc is close to the operational temperature range of the device). At Tc (and near Tc) capacitance density and tuning are the highest for a given material. However, the dielectric losses are the highest too, resulting in low Q (quality factor) for various such conventional devices. In other words, with these conventional dielectrics (e.g., certain conventional single-phase perovskite dielectrics including doped and modified grain structure materials), high tuning is typically a limiting factor for the high-frequency quality factor (Q). Various embodiments can provide potential improvement in this regard.

As described herein, a high-K polycrystalline dielectric can conventionally be modeled as a binary system: tunable high-K crystals and non-tunable highly defected grain boundary area. The grain boundary area in such a model is also sometimes called a "dead layer" (such as where, for example, crystal cubes meet at an angle and/or where there is a higher defect density), since this layer is suppressing tuning and is reducing Q. In this regard, it is believed that high frequency losses in the GHz region are the result of interaction of defects (phonons and polarons) with the RF field That is, ferroelectric domains and nano-domains are present in the paraelectric crystals as the crystalline defects locally distorting crystalline electric field. As charged defects, they interact with RF contributing to the overall RF losses. The density of such defects (and the magnitude of the corresponding losses) is higher near the Tc. Various embodiments can provide potential improvement in this regard.

As described herein, various embodiments can improve upon certain conventional tunable dielectrics based on BST thin films deposited using Metal Organic Deposition (MOD) and/or Reactive Sputtering which have been successfully implemented in certain tunable devices on Alumina substrates. Currently, such devices are fabricated with the consistent Wafer Probe (WP) yield of >90%. DC properties of this composition are typically meeting the requirements of certain applications. A Ba/Sr ratio of 0.55/0.45-0.45/0.55 of this composition is typically providing the desired capacitance density and a tuning ratio of > 4-5:1. However, the high frequency Q (f>2GHz) of certain conventional BST compositions with Ba/Sr ratio of Ba/Sr>0.45/0.55 needs improvement. Reduction of the Ba/Sr ratio typically shows an improvement of Q at the expense of capacitance density and tuning ratio. Various embodiments can provide potential improvement in this regard.

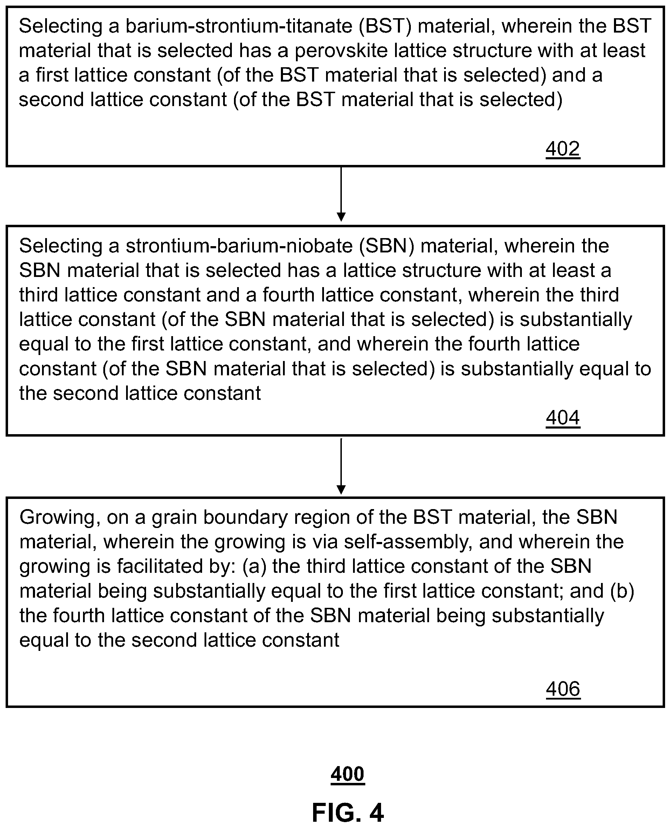

Referring now to **FIG. 4****,** various steps of a method 400 according to an embodiment are shown. As seen in this **FIG.** 4, step 402 comprises selecting a barium-strontium-titanate (BST) material, wherein the BST material that is selected has a perovskite lattice structure with at least a first lattice constant (of the BST material that is selected) and a second lattice constant (of the BST material that is selected). Next, step 404 comprises selecting a strontium-barium-niobate (SBN) material, wherein the SBN material that is selected has a lattice structure with at least a third lattice constant and a fourth lattice constant, wherein the third lattice constant (of the SBN material that is selected) is substantially equal to the first lattice constant, and wherein the fourth lattice constant (of the SBN material that is selected) is substantially equal to the second lattice constant. Next, step 406 comprises growing, on a grain boundary region of the BST material, the SBN material, wherein the growing is via self-assembly, and wherein the growing is facilitated by: (a) the third lattice constant of the SBN material being substantially equal to the first lattice constant; and (b) the fourth lattice constant of the SBN material being substantially equal to the second lattice constant. In another embodiment, the first lattice constant (of the BST material that is selected) can be substantially equal to the second lattice constant (of the BST material that is selected). In another embodiment, the third lattice constant (of the SBN material that is selected) can be substantially equal to the fourth lattice constant (of the SBN material that is selected).

While for purposes of simplicity of explanation, the respective processes are shown and described as a series of blocks in **FIG.** 4, it is to be understood and appreciated that the claimed subject matter is not limited by the order of the blocks, as some blocks may occur in different orders and/or concurrently with other blocks from what is depicted and described herein. Moreover, not all illustrated blocks may be required to implement the methods described herein.

It will be appreciated that various of the foregoing embodiments can be applied in the context of tunable device used in base stations, mobile communication devices, or other suitable communication system or devices.

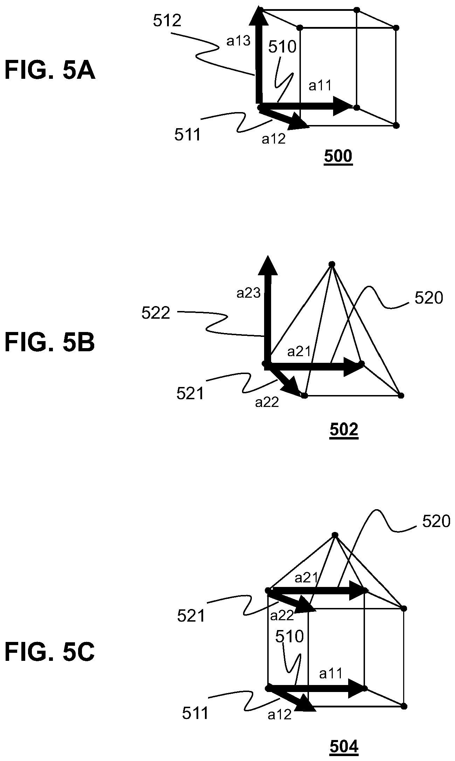

Referring now to **FIGs. 5A, 5B, and 5C****,** these figures depict representations of various crystals and self-assembly according to various embodiments. More particularly, **FIG. 5A** shows cubic crystal 500, in which all three lattice constants a11, a12, a13 are equal (a11=a12=a13). In this **FIG. 5A**, each of the lattice constants a11, a12, a13 is identified respectively by one of call out numbers 510, 511, 512. **FIG. 5B** shows tetragonal pyramidal crystal 502, where the base is the square rectangle. In tetragonal pyramidal crystal 502, only two lattice constants are equal (a21=a22; a23> (a21, a22)). In this **FIG. 5B**, each of the lattice constants a21, a22, a23 is identified respectively by one of call out numbers 520, 521, 522. **FIG. 5C** shows the self-assembly condition 504. The self-assembly of the tetragonal phase is favorable if a11=a12∼a21=a22. In this **FIG. 5C**, each of the lattice constants a11, a12 is identified respectively by one of call out numbers 510, 511 and each of the lattice constants a21, a22 is identified respectively by one of call out numbers 520, 521.

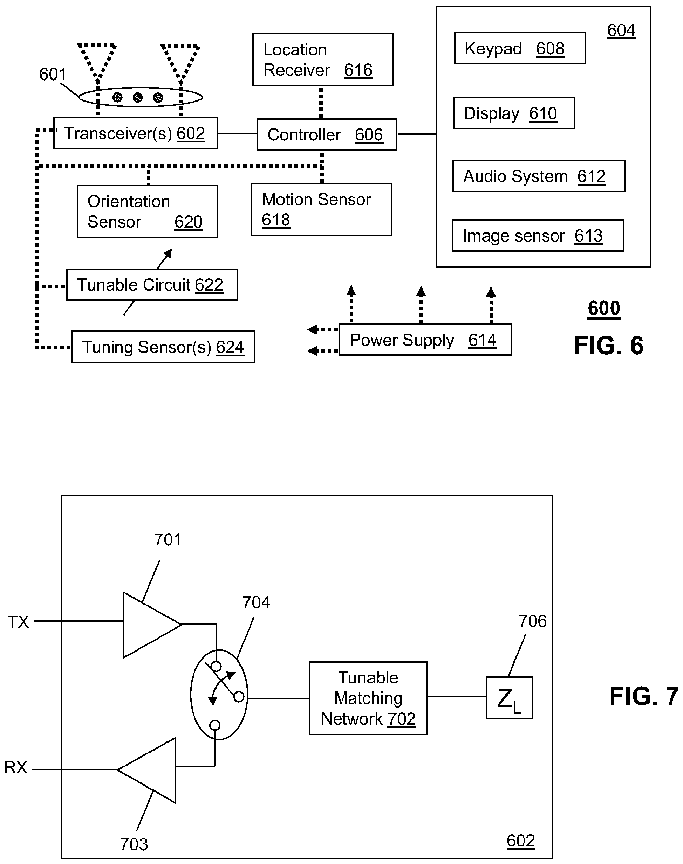

Referring now to **FIG. 6**, this depicts an illustrative embodiment of a communication device 600 which can utilize one or more aspects of the composition and/or dielectric tuning device described herein**.** The communication device 600 can comprise one or more transceivers 602 coupled to one or more antennas 601, each transceiver having transmitter and receiver sections (herein transceiver 602 or transceivers 602), a tunable circuit 622, one or more tuning sensors 624, a user interface (UI) 604, a power supply 614, a location receiver 616, a motion sensor 618, an orientation sensor 620, and a controller 606 for managing operations thereof. The transceiver 602 can support short-range or long-range wireless access technologies such as Bluetooth, ZigBee, Wireless Fidelity (WiFi), Digital Enhance Cordless Telecommunications (DECT), or cellular communication technologies, just to mention a few.

Cellular technologies can include, for example, Global System for Mobile (GSM), Code Division Multiple Access (CDMA), Time Division Multiple Access (TDMA), Universal Mobile Telecommunications (UMTS), World interoperability for Microwave (WiMAX), Software Defined Radio (SDR), Long Term Evolution (LTE), as well as other next generation wireless communication technologies as they arise. The transceiver 602 can also be adapted to support circuit-switched wireline access technologies such as Public Switched Telephone Network (PSTN), packet-switched wireline access technologies such as TCP/IP, Voice over IP—VoIP, etc., or combinations thereof.

The tunable circuit 622 can comprise variable reactive elements such as variable capacitors, variable inductors, or combinations thereof that are tunable with digital and/or analog bias signals. The tunable circuit 622 can represent a tunable matching network coupled to the antenna 601 to compensate for a change in impedance of the antenna 601, a compensation circuit to compensate for mutual coupling in a multi-antenna system, an amplifier tuning circuit to control operations of an amplifier of the transceiver 602, a filter tuning circuit to alter a pass band of a filter used by the transceiver 602, and so on.

The tuning sensors 624 can be placed at any stage of the transceiver 602 such as, for example, before or after a matching network 702, and/or at a power amplifier 701 as shown in **FIG.** 7. The tuning sensors 624 can utilize any suitable sensing technology such as directional couplers, voltage dividers, or other sensing technologies to measure signals at any stage of the transceiver 602. The digital samples of the measured signals can be provided to the controller 606 by way of analog-to-digital converters included in the tuning sensors 624. Data provided to the controller 606 by the tuning sensors 624 can be used to measure, for example, transmit power, transmitter efficiency, receiver sensitivity, power consumption of the communication device 600, frequency band selectivity by adjusting filter passbands, linearity and efficiency of power amplifiers, specific absorption rate (SAR) requirements, and so on. The controller 606 can be configured to execute one or more tuning algorithms to determine desired tuning states of the tunable circuit 622 based on the foregoing measurements.

The UI 604 can include a depressible or touch-sensitive keypad 608 with a navigation mechanism such as a roller ball, a joystick, a mouse, or a navigation disk for manipulating operations of the communication device 600. The keypad 608 can be an integral part of a housing assembly of the communication device 600 or an independent device operably coupled thereto by a tethered wireline interface (such as a USB cable) or a wireless interface supporting, for example, Bluetooth. The keypad 608 can represent a numeric keypad commonly used by phones, and/or a QWERTY keypad with alphanumeric keys. The UI 604 can further include a display 610 such as monochrome or color LCD (Liquid Crystal Display), OLED (Organic Light Emitting Diode) or other suitable display technology for conveying images to an end user of the communication device 600. In an embodiment where the display 610 is touch-sensitive, a portion or all of the keypad 608 can be presented by way of the display 610 with navigation features.

The display 610 can use touch screen technology to also serve as a user interface for detecting user input. As a touch screen display, the communication device 600 can be adapted to present a user interface with graphical user interface (GUI) elements that can be selected by a user with a touch of a finger. The touch screen display 610 can be equipped with capacitive, resistive or other forms of sensing technology to detect how much surface area of a user's finger has been placed on a portion of the touch screen display. This sensing information can be used to control the manipulation of the GUI elements or other functions of the user interface. The display 610 can be an integral part of the housing assembly of the communication device 600 or an independent device communicatively coupled thereto by a tethered wireline interface (such as a cable) or a wireless interface.

The UI 604 can also include an audio system 612 that utilizes audio technology for conveying low volume audio (such as audio heard in proximity of a human ear) and high volume audio (such as speakerphone for hands free operation). The audio system 612 can further include a microphone for receiving audible signals of an end user. The audio system 612 can also be used for voice recognition applications. The UI 604 can further include an image sensor 613 such as a charged coupled device (CCD) camera for capturing still or moving images.

The power supply 614 can utilize common power management technologies such as replaceable and rechargeable batteries, supply regulation technologies, and/or charging system technologies for supplying energy to the components of the communication device 600 to facilitate long-range or short-range portable applications. Alternatively, or in combination, the charging system can utilize external power sources such as DC power supplied over a physical interface such as a USB port or other suitable tethering technologies.

The location receiver 616 can utilize location technology such as a global positioning system (GPS) receiver capable of assisted GPS for identifying a location of the communication device 600 based on signals generated by a constellation of GPS satellites, which can be used for facilitating location services such as navigation. The motion sensor 618 can utilize motion sensing technology such as an accelerometer, a gyroscope, or other suitable motion sensing technology to detect motion of the communication device 600 in three-dimensional space. The orientation sensor 620 can utilize orientation sensing technology such as a magnetometer to detect the orientation of the communication device 600 (north, south, west, and east, as well as combined orientations in degrees, minutes, or other suitable orientation metrics).

The communication device 600 can use the transceiver 602 to also determine a proximity to or distance to cellular, WiFi, Bluetooth, or other wireless access points by sensing techniques such as utilizing a received signal strength indicator (RSSI) and/or signal time of arrival (TOA) or time of flight (TOF) measurements.

The controller 606 can utilize computing technologies such as a microprocessor, a digital signal processor (DSP), programmable gate arrays, application specific integrated circuits, and/or a video processor with associated storage memory such as Flash, ROM, RAM, SRAM, DRAM or other storage technologies for executing computer instructions, controlling, and processing data supplied by the aforementioned components of the communication device 600.

Still referring to **FIG.** 6, a tunable dielectric material according to one or more embodiments can be utilized by component(s) of this figure (e.g., utilized by the tunable circuit 622).

Other components not shown in **FIG.** 6 can be used by the subject disclosure. The communication device 600 can include a slot for inserting or removing an identity module such as a Subscriber Identity Module (SIM) card. SIM cards can be used for identifying and registering for subscriber services, executing computer programs, storing subscriber data, and so forth.

Referring now to **FIG.** 7, this depicts an illustrative embodiment of a portion of the wireless transceiver 602 of the communication device 600 of **FIG.** 6. It should be noted that an embodiment of transceiver 602 also could be utilized in a cellular base station to amplify RF communication signals prior to transmission by an antenna (e.g., antenna 706), and/or to amplify received RF signals from the antenna. In GSM applications, the transmit and receive portions of the transceiver 602 can include amplifiers 701, 703 coupled to a tunable matching network 702 that is in turn coupled to an impedance load 706. The impedance load 706 in the present illustration can be an antenna as shown in **FIG.** 7 (herein antenna 706). A transmit signal in the form of a radio frequency (RF) signal (TX) can be directed to the amplifier 701 which amplifies the signal and directs the amplified signal to the antenna 706 by way of the tunable matching network 702 when switch 704 is enabled for a transmission session. The receive portion of the transceiver 602 can utilize a pre-amplifier 703 which amplifies signals received from the antenna 706 by way of the tunable matching network 702 when switch 704 is enabled for a receive session. Other configurations of **FIG.** 7 are possible for other types of cellular access technologies such as CDMA, UMTS, LTE, and so forth. These undisclosed configurations are applicable to the subject disclosure.

Still referring to **FIG.** 7, a tunable dielectric material according to one or more embodiments can be utilized by component(s) of this figure (e.g., utilized by the tunable matching network 702).

Upon reviewing the aforementioned embodiments, it would be evident to an artisan with ordinary skill in the art that said embodiments can be modified, reduced, or enhanced without departing from the scope of the claims described below.

Other embodiments can be applied to the subject disclosure without departing from the scope of the claims described below.

It should be understood that devices described in various embodiments can be in communication with each other via various wireless and/or wired methodologies. The methodologies can be links that are described as coupled, connected and so forth, which can include unidirectional and/or bidirectional communication over wireless paths and/or wired paths that utilize one or more of various protocols or methodologies, where the coupling and/or connection can be direct (e.g., no intervening processing device) and/or indirect (e.g., an intermediary processing device such as a router).

In various embodiments, a machine in the form of a computer system can be provided. There can be a set of instructions within the machine. The instructions, when executed, can cause the machine to perform any one or more of the methods discussed herein. One or more instances of the machine can operate, for example, as the communication device 600 of **FIG.** 6. One or more instances of the machine can operate, for example, to select materials for production of compositions as described herein. One or more instances of the machine can operate, for example, to control machinery for production of compositions as described herein. In some embodiments, the machine may be connected (e.g., using a network) to other machines. In a networked deployment, the machine may operate in the capacity of a server or a client user machine in server-client user network environment, or as a peer machine in a peer-to-peer (or distributed) network environment.

A method that incorporates teachings of the subject disclosure may comprise, for example, selecting a barium-strontium-titanate (BST) material, wherein the BST material has a perovskite lattice structure with at least a first lattice constant and a second lattice constant; selecting a strontium-barium-niobate (SBN) material, wherein the SBN material has a lattice structure with at least a third lattice constant and a fourth lattice constant, wherein the third lattice constant is substantially equal to the first lattice constant, and wherein the fourth lattice constant is substantially equal to the second lattice constant; and growing, on a grain boundary region of the BST material, the SBN material, wherein the growing is via self-assembly, and wherein the growing is facilitated by the third lattice constant of the SBN material being substantially equal to the first lattice constant and the fourth lattice constant of the SBN material being substantially equal to the second lattice constant. Other embodiments are disclosed.

The machine may comprise a server computer, a client user computer, a personal computer (PC), a tablet PC, a smart phone, a laptop computer, a desktop computer, a control system, a network router, switch or bridge, or any machine capable of executing a set of instructions (sequential or otherwise) that specify actions to be taken by that machine. It will be understood that a communication device of the subject disclosure includes broadly any electronic device that provides voice, video or data communication. Further, while a single machine is illustrated, the term "machine" shall also be taken to include any collection of machines that individually or jointly execute a set (or multiple sets) of instructions to perform any one or more of the methods discussed herein.

In accordance with various embodiments of the subject disclosure, various methods described herein are intended for operation as software programs running on a computer processor. Furthermore, software implementations can include, but not be limited to, distributed processing or component/object distributed processing. Parallel processing, or virtual machine processing can also be constructed to implement the methods described herein.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated to achieve the same purpose may be substituted for the specific embodiments shown. This disclosure is intended to cover any and all adaptations or variations of various embodiments. Combinations of the above embodiments, and other embodiments not specifically described herein, are contemplated by the subject disclosure.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

## Claims

1. A method, comprising:
selecting a barium-strontium-titanate (BST) material, wherein the BST material that is selected has a perovskite lattice structure with at least a first lattice constant and a second lattice constant;
selecting a strontium-barium-niobate (SBN) material, wherein the SBN material that is selected has a lattice structure with at least a third lattice constant and a fourth lattice constant, wherein the third lattice constant is substantially equal to the first lattice constant, and wherein the fourth lattice constant is substantially equal to the second lattice constant; and
growing, on a grain boundary region of the BST material, the SBN material, wherein the growing is via self-assembly, and wherein the growing is facilitated by the third lattice constant of the SBN material being substantially equal to the first lattice constant and the fourth lattice constant of the SBN material being substantially equal to the second lattice constant.

2. The method of claim 1, wherein the BST material that is selected is in a form of Ba₁₋ₓSrₓTiO, and wherein x is in a range of 0.55-0.8, inclusive.

3. The method of claim 1, wherein the SBN material that is selected is in a form of SrₓBa₁₋ₓNb₂O₆, and wherein x is in a range of 0.5-0.7, inclusive.

4. The method of any preceding claim, wherein the SBN material being grown on the BST material results in a combined composition, and wherein presence of the SBN material on the grain boundary region provides a higher tuning ratio for the combined composition than would otherwise be provided without the growth on the grain boundary region.

5. The method of any preceding claim, wherein the growing comprises crystallization.

6. The method of claim 5, wherein the SBN material being grown on the BST material results in a tunable dielectric composition.

7. The method of any preceding claim, wherein:
the BST material that is selected comprises between 80%-99.9%, inclusive, of a total composition including the BST material that is selected and the SBN material that is selected; and
the SBN material that is selected comprises between 0.1%-20%, inclusive, of the total composition including the BST material that is selected and the SBN material that is selected.

8. The method of any preceding claim, wherein:
the first lattice constant is equal to the second lattice constant; and
the third lattice constant is substantially equal to the first lattice constant, the second lattice constant and the fourth lattice constant.

9. The method of any preceding claim , wherein:
the third lattice constant of the SBN material being substantially equal to the first lattice constant comprises the third lattice constant matching the first lattice constant within a threshold equal to +/- 0.5%; and
the fourth lattice constant of the SBN material being substantially equal to the second lattice constant comprises the fourth lattice constant matching the second lattice constant within the threshold equal to +/- 0.5%.

10. A tunable dielectric material, comprising:
a first layer formed of barium-strontium-titanate (BST), wherein the first layer comprises a grain boundary region, and wherein the BST in the grain boundary region of the first layer has a first lattice structure with first, second and third lattice constants; and
a second layer formed of strontium-barium-niobate (SBN) that is crystallized on the first layer, wherein the second layer has a second lattice structure with fourth, fifth and sixth lattice constants, wherein two of the fourth, fifth and sixth lattice constants substantially match two respective ones of the first, second and third lattice constants, and wherein the two of the fourth, fifth and sixth lattice constants substantially matching the two of the respective ones of the first, second and third lattice constants facilitates the second layer being crystallized on the first layer via self-assembly.

11. The tunable dielectric material of claim 10, wherein the BST is in a form of Ba₁₋ₓSrₓTiO, and wherein x is in a range of 0.55-0.8, inclusive.

12. The tunable dielectric material of claim 10 or 11, wherein the SBN is in a form of Sr_{y}Ba_{1-y}Nb₂O₆, and wherein y is in a range of 0.5-0.7, inclusive.

13. The tunable dielectric material of any of claims 10 to 12, wherein the crystallization of the second layer on the grain boundary region of the first layer provides a higher tuning ratio for the tunable dielectric material than would otherwise be provided without the crystallization.

14. The tunable dielectric material of any of claims 10 to 13, wherein:
the BST comprises between 80%-99.9%, inclusive, of a total composition including the BST and the SBN; and
the SBN comprises between 0.1%-20%, inclusive, of the total composition including the BST and the SBN.

15. The tunable dielectric material of any of claims 10 to 14, wherein the first lattice constant equals the second lattice constant, wherein the two of the fourth, fifth and sixth lattice constants substantially matching the two respective ones of the first, second and third lattice constants comprises a first one of the fourth, fifth and sixth lattice constants matching a first one of the first, second and third lattice constants within a threshold equal to +/- 0.5% and a second one of the fourth, fifth and sixth lattice constants matching a second one of the first, second and third lattice constants within the threshold equal to +/- 0.5%.
